# EUROPÄISCHE PATENTSCHRIFT

(11) **EP 0 765 954 B1**
(45) Veröffentlichungstag und Bekanntmachung des Hinweises auf die Patenterteilung: **28.04.1999**
(21) Anmeldenummer: 96113592.8
(22) Anmeldetag: 24.08.1996
(51) Int. Cl.: C30B 15/00, C30B 15/14

(54) **Kristallziehanlage**
Crystal pulling apparatus
Appareil pour le tirage des cristaux

(30) Priorität: 26.09.1995 DE 19535750; 23.10.1995 DE 19539316
(43) Veröffentlichungstag der Anmeldung: 02.04.1997
(73) Patentinhaber: Balzers und Leybold Deutschland Holding Aktiengesellschaft, 63450 Hanau (DE)
(72) Erfinder: Schulmann, Winfried, Dipl.-Ing., 63801 Kleinostheim (DE); Scholler, Johann, Ing., 64859 Eppertshausen (DE)
(74) Vertreter: Schlagwein, Udo, Dipl.-Ing.

(56) Entgegenhaltungen:
- DE-A- 2 821 481
- IBM TECHNICAL DISCLOSURE BULLETIN, Bd. 28, Nr. 1, Juni 1985, NEW YORK US, Seiten 211-212, XP002023174 "Apparatus for low to medium level oxygen czochralski silicon crystal growth"
- PATENT ABSTRACTS OF JAPAN vol. 8, no. 266 (C-255) [1703] & JP-A-59 141494 (HITACH SEISAKUSHO KK)

## Beschreibung

Die Erfindung betrifft eine Kristallziehanlage zur Erzeugung eines Kristallblockes aus einem in einem Tiegel schmelzbaren Material, wobei der Tiegel von einem Heizer umgeben und in einem Behälter angeordnet ist, dessen Wand mit einer thermischen Isolation und außenseitig mit Kühlkanälen für ein Kühlmedium versehen ist und wobei der Behälter zumindest einen Schutzgaseinlaß und einen Schutzgasauslaß hat.

Solche Kristallziehanlagen werden insbesondere zu Herstellung von Blöcken einkristallinen Siliziums oder Germaniums eingesetzt und sind deshalb in der Fachwelt bekannt. Dabei dient als Schutzgas meist Argon dazu, um den Zutritt von Sauerstoff zu verhindern. Dieses Schutzgas strömt üblicherweise oberhalb des Heizers in einen Ringraum außenseitig der thermischen Isolation des Behälters und wird dann über diesen Ringraum zwischen der thermischen Isolation und den Kühlkanälen abgeführt.

Es hat sich in der Praxis gezeigt, daß sich bei solchen Kristallziehanlagen auf dem Heizer und an den Innenwandungen des Behälters relativ rasch vom Schutzgas aufgenommene, staubförmige Stoffe niederschlagen, so daß die Anlagen in unerwünscht kurzen Abständen gereinigt werden müssen. Insbesondere schlägt sich bei der Erzeugung von Siliziumkristallblöcken Siliziumoxid an den Innenwandungen und dem Heizer nieder. Weiterhin ist der Energieverbrauch solcher Anlagen hoch.

Der Erfindung liegt das Problem zugrunde, eine Kristallziehanlage der eingangs genannten Art so zu gestalten, daß sie in einem möglichst geringen Maße zum Anlagern von Stoffen an ihren Wandungen und ihrem Heizer neigt und daß sie einen möglichst geringen Energieverbrauch hat.

Dieses Problem wird erfindungsgemäß dadurch gelöst, daß der Behälter im Bereich des Tiegels einen durch ein inneres Schutzrohr zum Heizer hin begrenzten, mit dem Schutzgasauslaß verbundenen Ringraum hat, welcher außenseitig durch ein äußeres Schutzrohr begrenzt ist, hinter welchem sich die thermische Isolation des Behälters befindet.

Bei einer solchen Kristallziehanlage ist das Schutzgas im Behälter durch die thermische Isolation vom Kühlmedium getrennt. Deshalb verläßt das Schutzgas den Behälter wesentlich heißer als beim Stand der Technik. Dadurch wird dem Kühlmedium, bei dem es sich meist um Wasser handelt, weniger Wärme zugeführt, so daß ein geringerer Kühlmittelstrom notwendig wird. Da das abzuführende Schutzgas nicht mehr vom Kühlmedium gekühlt wird, ergibt sich eine geringere Kondensationsrate von Stoffen im Schutzgas, wodurch sich die Standzeit der Anlage, insbesondere ihres Heizers, wesentlich erhöht. Durch den erfindungsgemäßen Ringraum um den Heizer herum entsteht in dem Behälter eine sehr gleichmäßige Temperaturverteilung, was für den Kristallziehvorgang vorteilhaft ist.

Eine besonders gleichmäßige Gasströmung und damit auch eine besonders gleichmäßige Temperaturverteilung im Behälter erhält man, wenn gemäß einer vorteilhaften Weiterbildung der Erfindung der Ringraum an seiner unteren Stirnseite von einer Siebplatte begrenzt ist, über welche eine Verbindung zu dem Schutzgasauslaß besteht.

Der für die Anordnung von Kristallziehanlagen vorhandene Platz wird optimal genutzt, wenn der Behälter in seinem Boden zwei axial zum Behälter ausgerichtete, zueinander gegenüberstehende Schutzgasauslässe hat.

Der Tiegel wird lediglich auf seiner Oberseite mit höherer Geschwindigkeit von dem Schutzgas umströmt, während in den weiter unten liegenden Bereichen das Schutzgas nahezu stillsteht, wenn gemäß einer Weiterbildung der Erfindung das innere Schutzrohr nach oben hin bis zur Oberkante des Heizers reicht. Durch diese Begrenzung des Stromes von Schutzgas ergibt es sich, daß in Bereichen mit niedrigerer Temperatur, wo die Gefahr einer Kondensation von mitgeführten gasförmigen Bestandteilen groß ist, nicht in größerem Maße Schutzgas strömt.

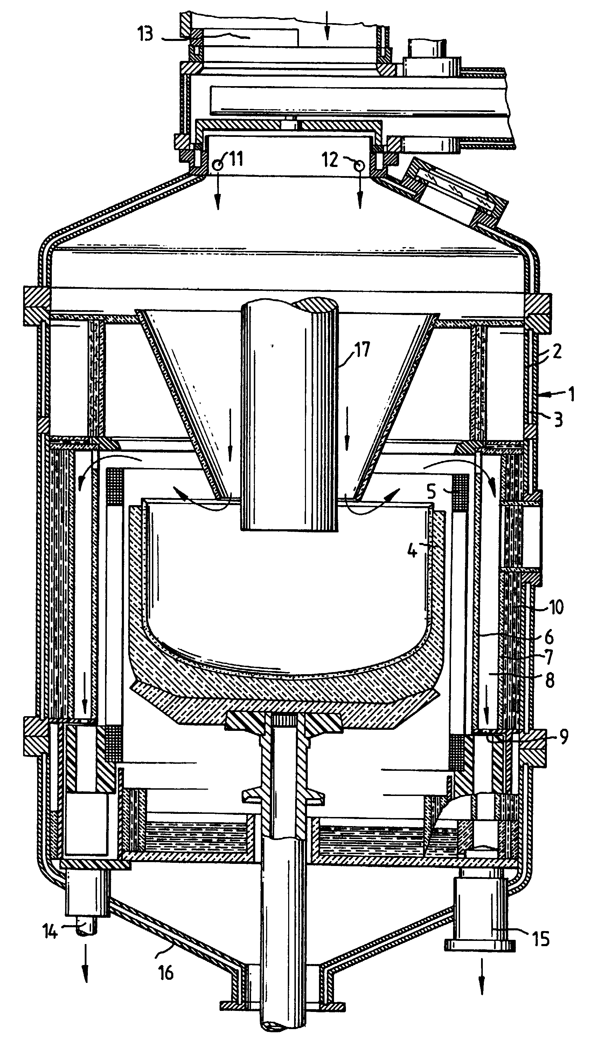

Die Erfindung läßt zahlreiche Ausführungsformen zu. Zur weiteren Verdeutlichung ihres Grundprinzips ist in der Zeichnung ein Längsschnitt durch eine Kristallziehanlage nach der Erfindung dargestellt und wird nachfolgend beschrieben.

Die Zeichnung zeigt einen Behälter 1, dessen Wand 2 doppelwandig ausgeführt ist, so daß in ihr Kühlkanäle 3 für ein Kühlmedium, üblicherweise Wasser, vorhanden sind. In dem Behälter 1 ist ein Tiegel 4 angeordnet, welcher von einem elektrischen Heizer 5 umgeben ist. Dieser Heizer 5 ist außenseitig mit geringem Abstand von einem inneren Schutzrohr 6 und einem äußeren Schutzrohr 7 umschlossen. Auf diese Weise wird zwischen den Schutzrohren 6, 7 ein Ringraum 8 gebildet, welcher an seiner unteren Stirnfläche durch eine ebenfalls ringförmige Siebplatte 9 begrenzt ist. Die Oberkante des inneren Schutzrohres 6 verläuft in Höhe der Oberkante des Heizers 5. Zwischen dem äußeren Schutzrohr 7 und der Wand 2 des Behälters 1 befindet sich im Bereich des Tiegels 4 eine thermische Isolation 10.

Schematisch angedeutet sind im oberen Bereich des Behälters 1 zwei Schutzgaseinlässe 11, 12. Durch diese und zugleich durch eine obere Öffnung 13 strömt während des Arbeitens der Kristallziehanlage Schutzgas, meist Argon, in den Behälter 1. Dieses Schutzgas verläßt den Behälter 1 über zwei Schutzgasauslässe 14, 15, welche einander gegenüberliegend axial zum Behälter 1 ausgerichtet in seinem Boden 16 vorgesehen sind und die jeweils über die Siebplatte 9 mit dem Ringraum 8 Verbindung haben.

Während des Arbeitens der Kristallziehanlage strömt Schutzgas von oben nach unten entlang eines schematisch angedeuteten Kristallblockes 17 zur Oberseite des Tiegels 4 und von dort über den Heizer 5 hinweg allseitig nach außen in den Ringraum 8, von wo es über die Schutzgasauslässe 14, 15 abgeführt wird. Auch der übrige Raum im Behälter 1 wird mit Schutzgas gefüllt, jedoch nimmt die Hauptströmung den zuvor beschriebenen Weg.

### Bezugszeichenliste

- 1: Behälter
- 2: Wand
- 3: Kühlkanäle
- 4: Tiegel
- 5: Heizer

- 6: inneres Schutzrohr
- 7: äußeres Schutzrohr
- 8: Ringraum
- 9: Siebplatte
- 10: thermische Isolation

- 11: Schutzgaseinlaß
- 12: Schutzgaseinlaß
- 13: Öffnung
- 14: Schutzgasauslaß
- 15: Schutzgasauslaß

- 16: Boden
- 17: Kristallblock

## Patentansprüche

1. Kristallziehanlage zur Erzeugung eines Kristallblockes aus einem in einem Tiegel schmelzbaren Material, wobei der Tiegel von einem Heizer umgeben und in einem Behälter angeordnet ist, dessen Wand mit einer thermischen Isolation und außenseitig mit Kühlkanälen für ein Kühlmedium versehen ist und wobei der Behälter zumindest einen Schutzgaseinlaß und einen Schutzgasauslaß hat, **dadurch gekennzeichnet,** daß der Behälter (1) im Bereich des Tiegels (4) einen durch ein inneres Schutzrohr (6) zum Heizer (5) hin begrenzten, mit dem Schutzgasauslaß (14, 15) verbundenen Ringraum (8) hat, welcher außenseitig durch ein äußeres Schutzrohr (7) begrenzt ist, hinter welchem sich die thermische Isolation (10) des Behälters (1) befindet.

2. Kristallziehanlage nach Anspruch 1, **dadurch gekennzeichnet,** daß der Ringraum (8) an seiner unteren Stirnseite von einer Siebplatte (9) begrenzt ist, über welche eine Verbindung zu dem Schutzgasauslaß (14, 15) besteht.

3. Kristallziehanlage nach den Ansprüchen 1 oder 2, **dadurch gekennzeichnet,** daß der Behälter (1) in seinem Boden (16) zwei axial zum Behälter (1) ausgerichtete, zueinander gegenüberstehende Schutzgasauslässe (14, 15) hat.

4. Kristallziehanlage nach zumindest einem der vorangehenden Ansprüche, **dadurch gekennzeichnet,** daß das innere Schutzrohr (6) nach oben hin bis zur Oberkante des Heizers (5) reicht.

## Claims

1. A crystal pulling apparatus for producing a crystal block from a material which can be melted in a crucible, the crucible being enclosed by a heater and being arranged in a receptacle, whose wall is provided with a thermal insulation and is provided on the outside with cooling ducts for a cooling medium, the receptacle having at least one protective gas inlet and one protective gas outlet, characterised in that, in the region of the crucible (4), the receptacle (1) has an annular chamber (8), which is defined in the direction of the heater (5) by an internal protective pipe (6), is connected to the protective gas outlet (14, 15) and is defined on the outside by an external protective pipe (7), behind which the thermal insulation (10) of the receptacle (1) is disposed.

2. A crystal pulling apparatus according to claim 1, characterised in that the annular chamber (8) is defined at its lower end face by a filter plate (9), via which a connection to the protective gas outlet (14, 15) is formed.

3. A crystal pulling apparatus according to claims 1 or 2, characterised in that, in its base (16), the receptacle (1) comprises two protective gas outlets (14, 15), which are arranged opposite one another and are axially oriented relative to the receptacle (1).

4. A crystal pulling apparatus according to at least one of the preceding claims, characterised in that the internal protective pipe (6) extends upwards to the upper edge of the heater (5).

## Revendications

1. Installation de tirage de cristaux pour la production d'un bloc de cristal à partir d'un matériau pouvant fondre dans un creuset, le creuset étant entouré d'un dispositif de chauffage et étant disposé dans un récipient dont la paroi est munie d'une isolation thermique et sur le côté externe de canaux de réfrigération pour un agent réfrigérant et le récipient présentant au moins une entrée de gaz inerte et une sortie de gaz inerte, caractérisée en ce que le récipient (1) présente dans le domaine du creuset (4) un espace annulaire (8) limité par un tuyau interne de protection (6) jusqu'au dispositif de chauffage (5), lié à la sortie de gaz inerte (14, 15), lequel est limité sur le côté externe par un tuyau externe de protection (7) derrière lequel se trouve l'isolation thermique (10) du récipient (1).

2. Installation pour le tirage de cristaux selon la revendication 1, caractérisée en ce que l'espace annulaire (8) est limité sur son côté avant inférieur par une plaque de tamis (9) par l'intermédiaire de laquelle est créée une liaison avec la sortie de gaz inerte (14, 15).

3. Installation pour le tirage de cristaux selon les revendications 1 ou 2, caractérisée en ce que le récipient (1) présente dans son fond (16) deux sorties de gaz inerte (14, 15) disposées axialement au récipient (1), se faisant face.

4. Installation pour le tirage de cristaux selon au moins l'une quelconque des revendications précédentes, caractérisée en ce que le tuyau interne de protection (6) s'étend vers le haut jusqu'à l'arête supérieure du dispositif de chauffage (5).
